# EUROPÄISCHE PATENTANMELDUNG

(11) **EP 4 654 464 A1**
(43) Veröffentlichungstag der Anmeldung: **26.11.2025**
(21) Anmeldenummer: 25177415.4
(22) Anmeldetag: 19.05.2025
(51) Int. Cl.: H02S 20/10, H02S 20/32, H02S 40/38, H10F 19/00

(54) **SOLARMODULBEFESTIGUNGSVORRICHTUNG**

(30) Priorität: 17.05.2024 DE 102024114006
(71) Anmelder: Zimmermann, Robert, 88436 Eberhardzell (DE)
(72) Erfinder: Zimmermann, Robert, 88436 Eberhardzell (DE)
(74) Vertreter: Daub, Thomas

(57) **Zusammenfassung**

Die Erfindung geht aus von einer Solarmodulbefestigungsvorrichtung mit einer Solarmodulbefestigungseinheit, zur Anbindung zumindest eines Solarmoduls (12, 14), mit zumindest einer rotierbaren Befestigungsachse (20), an der zumindest die eine Solarmodulbefestigungseinheit angebunden ist, mit einer Antriebseinheit (22), die zum Antrieb der Befestigungsachse (20) vorgesehen ist, und mit einem Steuerungsmodul (24), das zumindest ein Steuerungsmodulgehäuse (26) und eine in dem Steuerungsmodulgehäuse (26) angeordnete Steuereinheit (32) zur Steuerung der Antriebseinheit (22) aufweist.

Es wird vorgeschlagen, dass das Steuerungsmodul (24) ein in dem Steuerungsmodulgehäuse (26) angeordnetes Batteriefach (36) aufweist, das zur wechselbaren Aufnahme einer elektrischen Batterie (38) vorgesehen ist.

## Beschreibung

### Stand der Technik

Die Erfindung betrifft eine Solarmodulbefestigungsvorrichtung nach dem Oberbegriff des Patentanspruchs 1.

Es ist bereits eine Solarmodulbefestigungsvorrichtung mit einer Solarmodulbefestigungseinheit, zur Anbindung zumindest eines Solarmoduls, mit zumindest einer rotierbaren Befestigungsachse, an der zumindest die eine Solarmodulbefestigungseinheit angebunden ist, mit einer Antriebseinheit, die zum Antrieb der Befestigungsachse vorgesehen ist, und mit einem Steuerungsmodul, das zumindest ein Steuerungsmodulgehäuse und eine in dem Steuerungsmodulgehäuse angeordnete Steuereinheit zur Steuerung der Antriebseinheit aufweist, vorgeschlagen worden.

Die Aufgabe der Erfindung besteht insbesondere darin, eine gattungsgemäße Vorrichtung mit verbesserten Eigenschaften hinsichtlich einer Montage- und Wartungsfreundlichkeit bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

### Vorteile der Erfindung

Die Erfindung geht aus von einer Solarmodulbefestigungsvorrichtung mit einer Solarmodulbefestigungseinheit, zur Anbindung zumindest eines Solarmoduls, mit zumindest einer rotierbaren Befestigungsachse, an der zumindest die eine Solarmodulbefestigungseinheit angebunden ist, mit einer Antriebseinheit, die zum Antrieb der Befestigungsachse vorgesehen ist, und mit einem Steuerungsmodul, das zumindest ein Steuerungsmodulgehäuse und eine in dem Steuerungsmodulgehäuse angeordnete Steuereinheit zur Steuerung der Antriebseinheit aufweist.

Es wird vorgeschlagen, dass das Steuerungsmodul ein in dem Steuerungsmodulgehäuse angeordnetes Batteriefach aufweist, das zur wechselbaren Aufnahme einer elektrischen Batterie vorgesehen ist. Unter einer "Solarmodulbefestigungsvorrichtung" soll vorzugsweise eine Vorrichtung verstanden werden, mittels der Solarmodule auf einem Untergrund aufgestellt werden können. Die Solarmodulbefestigungsvorrichtung bildet eine tragende Struktur aus, mittels der die Solarmodule an dem Untergrund befestigt sind. Über die Solarmodulbefestigungsvorrichtung werden die Gewichtskraft der Solarmodule und weitere auf die Solarmodule wirkende Kräfte, wie beispielsweise Windkräfte, in den Untergrund abgeleitet. Die Solarmodulbefestigungsvorrichtung weist vorzugsweise ein Grundgestell auf. Das Grundgestell kann vorzugsweise mehrere Stützelemente aufweisen, die mit dem Untergrund fest verbunden sind. Unter einem "Stützelement" soll vorzugsweise ein Element verstanden werden, das fest mit dem Untergrund verbunden ist. Vorzugsweise ist das Stützelement in den Boden eingebracht. Unter "an dem Untergrund befestigt" soll vorzugsweise so mit dem Untergrund verbunden verstanden werden, dass Kräfte, vorzugsweise zumindest vertikal wirkende Kräfte, sowie seitlich wirkende Kräfte, in den Untergrund abgeleitet werden können. Vorzugsweise sind an dem Untergrund befestigte Elemente, wie die Stützelemente, in den Boden eingebracht, also insbesondere eingerammt, oder eingedreht. Grundsätzlich ist es vorzugsweise auch denkbar, dass ein Stützelement als ein Träger ausgebildet ist, der zur Verbindung mit einer Struktur, wie beispielsweise einem Dach, oder einem anderen Aufbau vorgesehen ist. Mittels der Solarmodulbefestigungsvorrichtung sind die Solarmodule schwenkbar angebunden.

Unter einem "Solarmodul" soll insbesondere ein Modul verstanden werden, welches dazu vorgesehen ist, eine Energie des Sonnenlichts umzuwandeln.

Vorzugsweise ist ein Solarmodul zur Erzeugung eines elektrischen Stroms aus Sonnenlicht vorgesehen. Vorzugsweise ist das Solarmodul als ein Photovoltaikmodul ausgebildet. Unter einer "rotierbaren Befestigungsachse" soll vorzugsweise eine Achse verstanden werden, die als eine Stange, als ein Stab, als ein Holm oder dergleichen ausgebildet ist. Die Befestigungsachse weist vorzugsweise eine Länge von zumindest 5 m, besonders bevorzugt von zumindest 10 m auf und kann in vorteilhaften Ausgestaltungen auch zwischen 20 m und 50 m betragen. Die Länge einer Befestigungsachse ist abhängig von einem Terrain, auf dem die Solarmodulbefestigungsvorrichtung aufgestellt ist. Die Befestigungsachse ist je nach Länge aus zumindest einem einstückigen Rohrelement gebildet. Unter einer "Antriebseinheit" soll vorzugsweise eine elektrische Antriebseinheit verstanden werden, die dazu vorgesehen ist, eine Antriebskraft zur Rotation der Solarmodule bereitzustellen. Die Antriebseinheit ist vorzugsweise als ein Elektromotor ausgebildet.

Unter einem "Steuerungsmodul" soll vorzugsweise ein Modul verstanden werden, das zur Steuerung zumindest eines Teils der Solarmodulbefestigungsvorrichtung vorgesehen ist. Vorzugsweise ist das Steuerungsmodul zumindest dazu vorgesehen, die Antriebseinheit anzusteuern, um eine Ausrichtung der Solarmodule zu steuern. Neben einer Steuereinheit weist das Steuerungsmodul vorzugsweise weitere Bauteile auf, wie beispielsweise eine Sicherungseinheit, einen Notausschalter und elektrische Steckerelemente zur elektrischen Anbindung des Steuerungsmoduls. Unter einem "Steuerungsmodulgehäuse" soll vorzugsweise ein Gehäuse des Steuerungsmoduls verstanden werden, das zumindest einen geschlossenen Innenraum aufspannt, in dem Bauteile des Steuerungsmoduls angeordnet sind. Das Steuerungsmodulgehäuse ist vorzugsweise aus einem Metall gebildet. Grundsätzlich ist es aber auch denkbar, dass das Steuerungsmodulgehäuse aus einem anderen Material, beispielsweise einem Kunststoff, insbesondere einem faserverstärkten Kunststoff gebildet ist. Vorzugsweise ist das Steuerungsmodulgehäuse aus einem witterungsbeständigen Material gebildet. Unter einer "Steuereinheit" soll vorzugsweise eine elektronische Einheit verstanden werden, die vorzugsweise zumindest eine Recheneinheit und insbesondere zusätzlich zur Recheneinheit eine Speichereinheit mit einem darin gespeicherten Steuer- und/oder Regelprogramm aufweist, das dazu vorgesehen ist, von der Recheneinheit ausgeführt zu werden.

Unter einem "Batteriefach" soll vorzugsweise ein Aufnahmebereich verstanden werden, der zur Aufnahme zumindest einer Batterie vorgesehen ist, in der die zumindest eine Batterie elektrisch anbindbar ist. In dem Batteriefach ist die zumindest eine Batterie vorzugsweise elektrisch mit dem Steuerungsmodul angebunden. Das Batteriefach ist dazu vorgesehen, dass zumindest eine Batterie zur Versorgung des Steuerungsmoduls mit einer elektrischen Energie darin angeordnet werden kann. Vorzugsweise ist das Batteriefach dazu vorgesehen, eine Batterie aufzunehmen, mittels deren elektrischer Energie die Solarmodulbefestigungsvorrichtung zumindest teilweise gesteuert werden kann, insbesondere eine Änderung der Ausrichtung der schwenkbar gelagerten Solarmodule mittels der Antriebseinheit. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt. Dadurch kann ein besonders vorteilhaft kompaktes Steuerungsmodul bereitgestellt werden, in das eine Batterie einfach austauschbar angebunden ist.

Weiter wird vorgeschlagen, dass das Batteriefach eine Gleitschieneneinheit aufweist, über die die Batterie in das Batteriefach einschiebbar ist. Unter einer "Gleitschieneneinheit" soll vorzugsweise eine Einheit verstanden werden, die zumindest eine Gleitschiene aufweist, auf der eine Batterie geführt lagerbar ist, insbesondere geführt in das Batteriefach einbringbar ist. Eine Batterie ist entlang einer Gleitachse der Gleitschieneneinheit geführt verschiebbar. Vorzugsweise gleitet eine Batterie mit korrespondierend ausgebildeten Auflageflächen auf der Gleitschieneneinheit, insbesondere auf der zumindest einen Gleitschiene. Vorzugsweise weist eine Batterie Führungselemente, vorzugsweise Formschlusselemente oder Führungsschienen auf, die die korrespondierenden Auflageflächen ausbilden. Vorzugsweise sind die Auflageflächen einer Batterie als korrespondierend ausgebildete Führungsschienen gebildet. Grundsätzlich wäre es auch denkbar, dass die Auflageflächen der Batterie von einer Seite, beispielsweise einer Unterseite, oder einer Seitenfläche der Batterie, insbesondere eines Gehäuses der Batterie ausgebildet sind. Unter einer "Gleitschiene" soll vorzugsweise eine Schiene verstanden werden, auf der eine Batterie geführt gelagert, insbesondere in einen Innenraum des Batteriefachs eingeschoben werden kann. Eine Gleitschiene bildet vorzugsweise eine Gleitfläche aus, auf der eine Batterie mit ihrer korrespondierend ausgebildeten Auflagefläche gleitend gelagert werden kann, um diese entlang einer Gleitachse zu verschieben. Dadurch kann das Batteriefach besonders vorteilhaft für eine einfache Wechslung einer Batterie ausgebildet werden.

Ferner wird vorgeschlagen, dass das Steuerungsmodul einen Hochvoltbereich und einen Niedervoltbereich aufweist, die in dem Steuerungsmodulgehäuse getrennt voneinander angeordnet sind, wobei das Batteriefach in dem Niedervoltbereich angeordnet ist. Unter einem "Hochvoltbereich" soll vorzugsweise ein Bereich verstanden werden, in dem Hochvoltkomponenten des Steuerungsmoduls angeordnet sind. Vorzugsweise sind Hochvoltkomponenten, die in dem Hochvoltbereich angeordnet sind, insbesondere Teile eines Stromkreises zur Leitung des von den Solarmodulen erzeugten Stroms. Der Hochvoltbereich ist als ein Bereich ausgebildet, in dem Spannungen anliegen, die größer sind als 100 Volt, vorzugsweise größer sind als 1000 Volt, insbesondere größer als 1,5 Kilovolt. Die Komponenten in dem Hochvoltbereich sind für Spannungen größer als 100 Volt, vorzugsweise Spannungen größer als 1000 Volt, insbesondere für Spannungen von mindestens 1,5 Kilovolt ausgelegt. Unter einem "Niedervoltbereich" soll vorzugsweise ein Bereich verstanden werden, in dem Spannungen anliegen, die kleiner sind als 30 Volt, vorzugsweise ca. 24 Volt betragen. Die Komponenten des Niedervoltbereichs sind für Spannungen kleiner 30 Volt, insbesondere für 24 Volt oder kleiner ausgelegt. Unter "getrennt voneinander" soll vorzugsweise räumlich voneinander getrennt verstanden werden, wobei die beiden Bereiche vorzugsweise durch ein Trennelement, wie insbesondere durch eine Trennwand voneinander getrennt sind. Unter "getrennt voneinander" soll außerdem elektrisch voneinander getrennt verstanden werden. Der Hochvoltbereich und der Niedervoltbereich sind elektrisch voneinander abgeschirmt, also gegeneinander galvanisch isoliert. Dadurch kann das Steuerungsmodul besonderes sicher ausgebildet werden, indem das Batteriefach von einem potentiell gefährlichen Hochvoltbereich räumlich getrennt ausgebildet ist.

Es wird weiterhin vorgeschlagen, dass der Hochvoltbereich durch zumindest eine Trennwand, vorzugsweise galvanisch isoliert, von dem Niedervoltbereich abgetrennt ist. Unter einer "Trennwand" soll vorzugsweise ein Wandelement verstanden werden, das den Hochvoltbereich und den Niedervoltbereich so voneinander abtrennt, dass ein Eingreifen in den Hochvoltbereich von dem Niedervoltbereich aus nicht möglich ist. Vorzugsweise trennt die Trennwand den Niedervoltbereich vollständig von dem Hochvoltbereich ab. Dadurch kann der Hochvoltbereich besonders vorteilhaft von dem Niedervoltbereich abgetrennt werden und ein besonders sicheres Steuerungsmodul bereitgestellt werden.

Des Weiteren wird vorgeschlagen, dass das Batteriefach ein elektrisches Kontaktmodul aufweist, das dazu vorgesehen ist, mit einer in dem Batteriefach korrekt angeordneten Batterie automatisch elektrisch verbunden zu werden. Unter einem "elektrischen Kontaktmodul" soll vorzugsweise ein Modul verstanden werden, das zwei elektrische Kontakte aufweist, also insbesondere einen Pluspol und einen Minuspol, die dazu eingerichtet sind, mit einer korrekt in dem Batteriefach angeordneten Batterie elektrisch kontaktiert zu werden. Unter "automatisch elektrisch verbunden" soll vorzugsweise verstanden werden, dass die elektrischen Kontakte des Kontaktmoduls selbsttätig mit den korrespondierenden elektrischen Kontakten einer in das Batteriefach eingeschobenen Batterie in Kontakt kommen, wenn die Batterie korrekt in einer Verbindungsposition in dem Batteriefach angeordnet ist. Dadurch kann das Batteriefach besonders vorteilhaft zu einer einfachen Anbindung einer Batterie ausgebildet werden.

Weiterhin wird vorgeschlagen, dass das Batteriefach zumindest ein Steckerelement zur manuellen elektrischen Verbindung einer in dem Batteriefach angeordneten Batterie aufweist. Unter einem "Steckerelement" soll vorzugsweise ein Steckelement mit zumindest zwei elektrischen Kontaktelementen verstanden werden, die zu einer elektrischen Kopplung mit korrespondierenden Kontaktelementen einer Batterie vorgesehen sind. Es ist denkbar, dass das Batteriefach je elektrischem Pol ein separates Steckerelement aufweist. Es wäre also denkbar, dass das Batteriefach ein Steckerelement für einen Pluspol und ein separates Steckerelement für einen Minuspol einer Batterie aufweist. Grundsätzlich wäre es ebenso denkbar, dass das Batteriefach ein Steckerelement aufweist, das ein Kontaktelement für einen Minuspol und ein Kontaktelement für einen Pluspol einer Batterie aufweist. Vorzugsweise ist es denkbar, dass ein Batteriefach unterschiedliche Steckerelemente zur Anbindung an unterschiedliche Bauarten von Batterien, insbesondere mit unterschiedlich ausgebildeten Steckerelementen für den Plus- und Minuspol, aufweist. Dadurch kann das Batteriefach besonders flexibel zur Anbindung unterschiedlicher Batterien ausgebildet werden.

Das zumindest eine Steckerelement zur manuellen elektrischen Verbindung mit einer Batterie in dem Batteriefach kann alternativ zu dem elektrischen Kontaktmodul zur automatischen elektrischen Anbindung einer Batterie vorgesehen sein. Grundsätzlich wäre aber auch denkbar, dass in dem Batteriefach sowohl das zumindest eine Steckerelement zur manuellen elektrischen Verbindung mit einer Batterie in dem Batteriefach als auch das elektrische Kontaktmodul zur automatischen elektrischen Anbindung einer Batterie in dem Batteriefach vorgesehen ist. Durch das Vorsehen beider Verbindungsmöglichkeiten könnte eine besonders hohe Flexibilität bei der Auswahl an verwendbaren Batterien erreicht werden.

Außerdem wird vorgeschlagen, dass das Batteriefach zu einer werkzeuglosen Montage, insbesondere zu einem werkzeuglosen Austausch einer Batterie vorgesehen ist. Dadurch kann das Batteriefach besonders vorteilhaft zu einem einfachen Austausch einer Batterie ausgebildet werden.

Zudem wird vorgeschlagen, dass das Steuerungsmodul dazu vorgesehen ist, die Steuereinheit wahlweise von einer in dem Batteriefach angeordneten Batterie, oder von einer externen Energiequelle, vorzugsweise von dem zumindest einen Solarmodul mit elektrischer Energie zu versorgen.

Dadurch kann in einem Betrieb, in dem die Solarmodule eines Solarmodulsystems genügend elektrische Energie bereitstellen, eine Energieversorgung zur Steuerung der Solarmodulbefestigungsvorrichtung durch die Solarmodule erfolgen und nur wenn diese nicht genügend elektrische Energie erzeugen, die Energieversorgung durch eine Batterie im Batteriefach bereitgestellt werden.

Weiter wird vorgeschlagen, dass das Steuerungsmodul mit seinem Steuerungsmodulgehäuse an der Befestigungsachse starr montiert ist. Dadurch kann das Steuerungsmodul besonders vorteilhaft und einfach angebunden werden.

Zudem wird vorgeschlagen, dass das Steuerungsmodulgehäuse ein Hauptgehäuse, das einen Hauptaufnahmeraum ausbildet, und eine Innenschale aufweist, die zumindest teilweise in dem Hauptaufnahmeraum angeordnet ist. Unter einem "Hauptgehäuse" soll vorzugsweise ein tragender Grundkörper des Steuerungsmodulgehäuses verstanden werden, das einen äußeren Abschluss des Steuerungsmodulgehäuses bildet. Das Hauptgehäuse bildet eine Außenwandung des Steuerungsmodulgehäuses aus und ist vorzugsweis zumindest zu 4 Seiten, vorzugsweise zu 5 Seiten hin geschlossen. Auf einer Seite weist das Hauptgehäuse vorzugsweise eine Öffnung auf, durch die ein von dem Hauptgehäuse aufgespannter Hauptaufnahmeraum zugänglich ist. Unter einer "Innenschale" soll vorzugsweise ein Schalenförmig ausgebildetes Element verstanden werden, das dazu vorgesehen ist mit dem Hauptgehäuse verbunden zu werden und sich zumindest teilweise in den von dem Hauptgehäuse aufgespannten Hauptaufnahmeraum zu erstrecken. Die Innenschale ist dazu vorgesehen den Hauptaufnahmeraum des Hauptgehäuses zu begrenzen. Die Innenschale bildet einen Aufnahmebereich aus, der von dem Hauptaufnahmeraum des Hauptgehäuses getrennt ausgebildet ist. Dadurch kann das Steuerungsmodulgehäuse besonders vorteilhaft ausgebildet werden.

Es wird weiter vorgeschlagen, dass die Innenschale einen Aufnahmebereich aufweist, der das Batteriefach ausbildet. Dadurch kann das Batteriefach besonders vorteilhaft von einem Hochvoltbereich räumlich getrennt werden.

Ferner wird ein Solarsystem mit einer Solarmodulbefestigungsvorrichtung, mit einem Steuerungsmodul, das ein Batteriefach aufweist, und mit einer Batterie, die wechselbar, insbesondere werkzeuglos wechselbar, in dem Batteriefach angeordnet ist, vorgeschlagen. Dadurch kann ein besonders vorteilhaftes Solarsystem bereitgestellt werden, bei dem eine Batterie zum Betrieb eines Steuerungsmoduls und einer Antriebseinheit besonders einfach gewechselt werden kann.

Die erfindungsgemäße Solarmodulbefestigungsvorrichtung soll hierbei nicht auf die oben beschriebene Anwendung und Ausführungsform beschränkt sein. Insbesondere kann die erfindungsgemäße Solarmodulbefestigungsvorrichtung zu einer Erfüllung einer hierin beschriebenen Funktionsweise eine von einer hierin genannten Anzahl von einzelnen Elementen, Bauteilen und Einheiten abweichende Anzahl aufweisen.

### Zeichnungen

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine schematische Ansicht eines Solarsystems mit einer Solarmodulbefestigungsvorrichtung, die eine rotierbare Befestigungsachse und ein daran befestigtes Steuerungsmodul aufweist,
- Fig. 2: eine schematische Ansicht des Steuerungsmoduls einer Solarmodulbefestigungsvorrichtung in einem ersten Ausführungsbeispiel, mit seinem Batteriefach und einer darin anordenbaren Batterie,
- Fig. 3: eine weitere schematische Darstellung des Steuerungsmoduls, und
- Fig. 4: eine stark schematisierte Schnittansicht durch das Steuerungsmodul,
- Fig. 5: eine schematische Explosionsdarstellung eines Steuerungsmoduls einer Solarmodulbefestigungsvorrichtung in einem zweiten Ausführungsbeispiel, mit seinem Batteriefach und einer darin anordnenbaren Batterie, und
- Fig. 6: eine schematische Schnittansicht des Steuerungsmoduls in dem zweiten Ausführungsbeispiel.

### Beschreibung der Ausführungsbeispiele

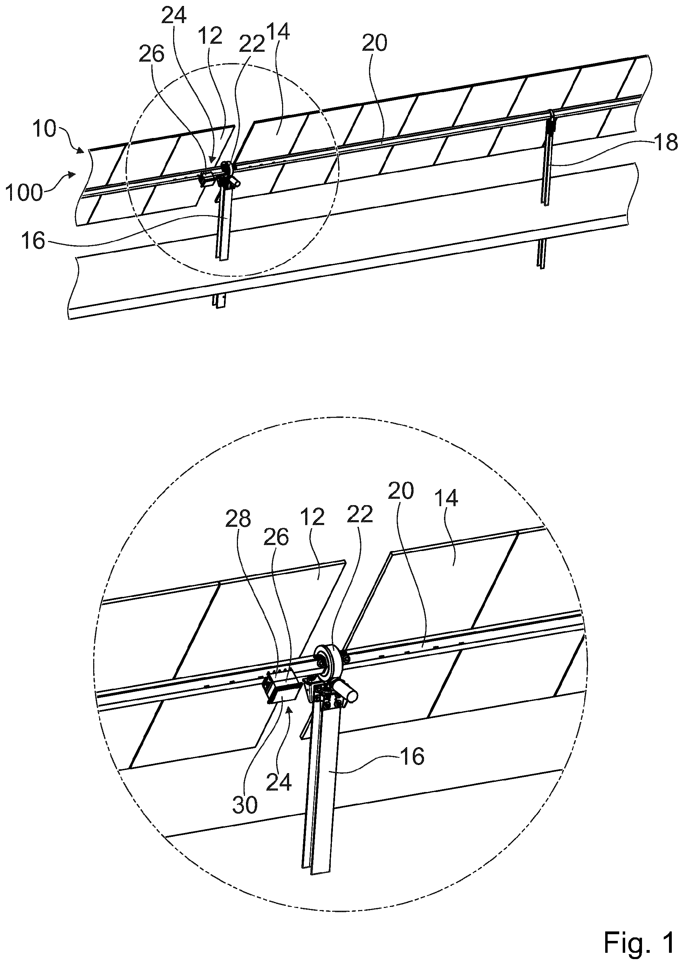

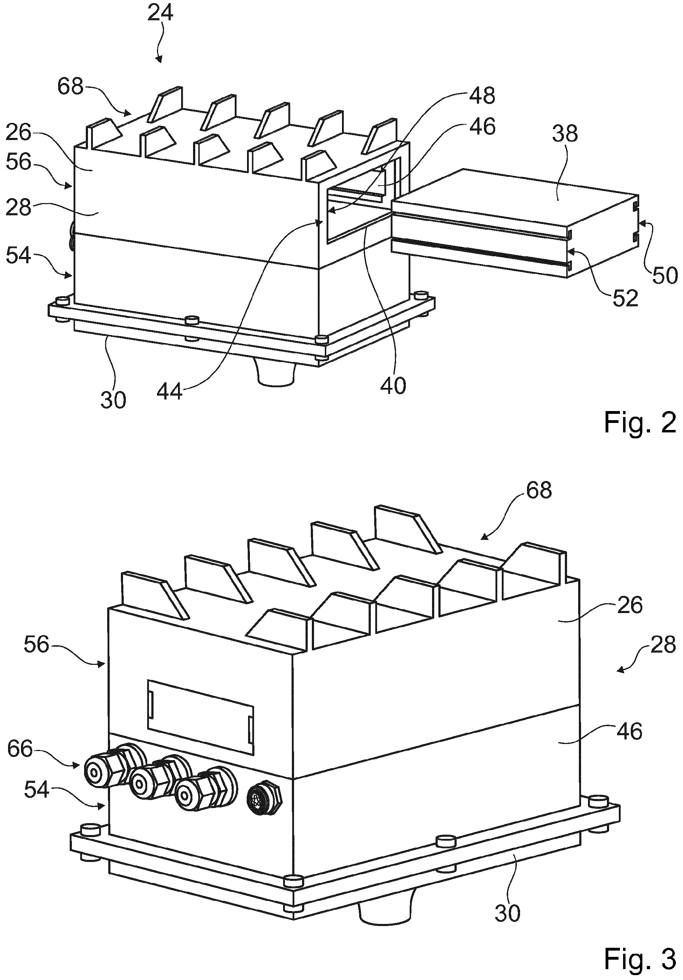

Die Figuren 1 bis 4 zeigen eine erfindungsgemäße Solarmodulbefestigungsvorrichtung 10 in einem ersten Ausführungsbeispiel. Die Solarmodulbefestigungsvorrichtung 10 ist Teil eines erfindungsgemäßen Solarsystems 100. Das Solarsystem 100 ist in der Figur lediglich teilweise dargestellt. Vorzugsweise kann das Solarsystem 100 eine Vielzahl von Solarmodulbefestigungsvorrichtungen 10 aufweisen, die beispielsweise nebeneinander angeordnet sind. Das Solarsystem 100 umfasst eine Vielzahl von Solarmodulen 12, 14, die mittels einer Solarmodulbefestigungsvorrichtung 10 auf einem Untergrund aufgeständert sind. Die Solarmodulbefestigungsvorrichtung 10 ist dazu vorgesehen eine Vielzahl von Solarmodulen 12, 14 in einer Reihe auf einem Untergrund aufzuständern. Die Solarmodulbefestigungsvorrichtung 10 ist dazu vorgesehen, die Solarmodule 12, 14 schwenkbar zu lagern. Die Solarmodulbefestigungsvorrichtung 10 ist zur sonnenstandfolgenden Aufständerung der Solarmodule 12, 14 auf dem Untergrund vorgesehen. Die Solarmodulbefestigungsvorrichtung 10 ist dazu vorgesehen, die Solarmodule 12, 14 schwenkbar zu lagern. Mittels der Solarmodulbefestigungsvorrichtung 10 sind die Solarmodule 12, 14 schwenkbar gelagert und können je nach Sonnenstand und Witterungsbedingungen unterschiedlich geneigt werden. Durch die schwenkbare Lagerung mittels der Solarmodulbefestigungsvorrichtung 10 können die Solarmodule 12, 14 sonnenstandfolgend geschwenkt werden. Dadurch können die Solarmodule 12. 14 über einen Tag hinweg immer möglichst effizient betrieben werden, indem sie der Sonne optimal zugewandt sind. Vorzugsweise sind die Solarmodule 12, 14 mittels der Solarmodulbefestigungsvorrichtung 10 in unterschiedliche Sicherungsstellungen verstellbar, in die die Solarmodule 12, 14 bei unterschiedlichen Witterungsbedingungen ausgerichtet werden. Die Solarmodule 12, 14 können mittels der Solarmodulbefestigungsvorrichtung 10 beispielsweise in eine Starkwindposition gebracht werden, in der diese eine möglichst geringe Windangriffsfläche ausbilden. In der Starkwindposition sind die Solarmodule 12, 14 vorzugsweise in einer horizontalen Ausrichtung ausgerichtet. Grundsätzlich wäre es auch denkbar, dass die Solarmodule 12, 14 in einer Starkwindposition in einem definierten, vorzugsweise flachen Winkel zu einem Untergrund ausgerichtet sind. Grundsätzlich wäre es auch denkbar, dass die Solarmodule 12, 14, je nach Windstärke und Windrichtung in unterschiedlichen Starkwindpositionen ausgerichtet werden.

Die Solarmodulbefestigungsvorrichtung 10 weist mehrere Stützelemente 16, 18 auf, über die die Solarmodulbefestigungsvorrichtung 10 an einem Untergrund befestigt ist. Die Stützelemente 16, 18 sind fest mit dem Untergrund verbunden.

Die Stützelemente 16, 18 sind je nach Untergrund, auf dem die Solarmodulbefestigungsvorrichtung 10 aufgestellt ist, unterschiedlich ausgebildet. Beispielsweise können die Stützelemente 16, 18 als Rammprofile ausgebildet sein, die in den Untergrund eingebracht sind. Grundsätzlich können die Stützelemente 16, 18 auch mit dem Untergrund verschraubt sein. Die Stützelemente 16, 18 sind vorzugsweise von Metallträgern, insbesondere Stahlträgern gebildet. Die Solarmodulbefestigungsvorrichtung 10 weist eine Befestigungsachse 20 auf. Die Befestigungsachse 20 ist zur Anbindung mehrerer Solarmodule 12, 14 vorgesehen. Die Befestigungsachse 20 ist als eine durchgehende Achse ausgebildet. Die Befestigungsachse 20 ist vorzugsweise als ein Rohr ausgebildet. Die Befestigungsachse 20 weist eine Außenkontur auf, die als ein Oktagon ausgebildet ist. Der Außenquerschnitt der Befestigungsachse 20 ist als ein Oktagon ausgebildet. Der Befestigungsachse 20 ist vorzugsweise als ein Oktagon-Hohlzylinder ausgebildet. Die Befestigungsachse 20 ist vorzugsweise aus einem Metall gebildet. Beispielsweise ist die Befestigungsachse 20 aus einem Stahl gebildet. Grundsätzlich ist es auch denkbar, dass die Befestigungsachse 20 aus einem anderen Material gebildet sind. Vorzugsweise weist die Befestigungsachse 20 einen Außendurchmesser von etwa 13 cm auf. Grundsätzlich ist es denkbar, dass die Befestigungsachse 20 einen Außendurchmesser aufweist, der vorzugsweise in einem Bereich von 10 cm bis 20 cm liegt. Grundsätzlich wäre es auch denkbar, dass die Befestigungsachse 20 einen anderen Querschnitt aufweist.

Die Befestigungsachse 20 ist zur Aufständerung mehrerer Solarmodule 12, 14 vorgesehen. An die Befestigungsachse 20 sind eine Vielzahl von Solarmodulen 12, 14 montiert. Die Solarmodule 12, 14 sind starr an die Befestigungsachse 20 angebunden. Die Solarmodule 12, 14 sind positionsfest an der Befestigungsachse 20 montiert. Die Solarmodulbefestigungsvorrichtung 10 weist zur Anbindung eines Solarmoduls 12, 14 eine Solarmodulbefestigungseinheit auf. Die Solarmodulbefestigungseinheit ist zur Anbindung eines der Solarmodule 12, 14 an die rotierbare Befestigungsachse 20 vorgesehen. Über die Solarmodulbefestigungseinheit ist ein Solarmodul 12, 14 an die Befestigungsachse 20 starr und drehfest montierbar. Grundsätzlich wäre es auch denkbar, dass über eine Solarmodulbefestigungseinheit mehrere Solarmodule 12, 14 fest an die rotierbare Befestigungsachse 20 anbindbar sind. Die Solarmodulbefestigungseinheit umfasst vorzugsweise zwei Halteelemente. Die Halteelemente sind jeweils in Seitenbereichen des Solarmoduls 12, 14 angeordnet. Das Solarmodul 12, 14 liegt vorzugsweise in Seitenbereichen auf den Halteelementen auf und ist an diesen montiert. Das Solarmodul 12 ist starr mit der Solarmodulbefestigungseinheit, insbesondere den Halteelementen verbunden. Die Befestigungsachse 20 bildet eine Rotationsachse aus. Die Rotationsachse ist vorzugsweise als eine Mittelängsachse der Befestigungsachse 20 ausgebildet. Die Rotationsachse ist als eine Achse ausgebildet, um die sich die Befestigungsachse 20 zur Verschwenkung der an ihr angebundenen Solarmodule 12, 14 dreht.

Die Solarmodulbefestigungsvorrichtung 10 weist eine Antriebseinheit 22 auf. Die Antriebseinheit 22 ist dazu vorgesehen, eine Rotation auf die Befestigungsachse 20 zu übertragen. Die Antriebseinheit 22 ist an der Befestigungsachse 20 montiert. Die Antriebseinheit 22 ist vorzugsweise als eine Motoreinheit, insbesondere als ein Elektromotor ausgebildet. Die Antriebseinheit 22 ist vorzugsweise direkt an die Befestigungsachse 20 angebunden. Grundsätzlich wäre es auch denkbar, dass die Antriebseinheit 22 über eine Getriebeeinheit an die Befestigungsachse 20 angebunden ist. Die Antriebseinheit 22 ist dazu vorgesehen, in einem Betrieb die Befestigungsachse 20 zu drehen, um die Solarmodule 12, 14 zu verschwenken.

Die Solarmodulbefestigungsvorrichtung 10 weist ein Steuerungsmodul 24 auf. Das Steuerungsmodul 24 ist zur Steuerung der Solarmodulbefestigungsvorrichtung 10 vorgesehen. Das Steuerungsmodul 24 ist zur Steuerung der Antriebseinheit 22 zur Rotation der Befestigungsachse 20 und dadurch der an der Befestigungsachse 20 angebundenen Solarmodule 12, 14 vorgesehen.

Das Steuerungsmodul 24 weist ein Steuerungsmodulgehäuse 26 auf. Das Steuerungsmodulgehäuse 26 bildet eine Umhausung für das Steuerungsmodul 24. Das Steuerungsmodulgehäuse 26 spannt einen Innenraum des Steuerungsmoduls 24. Das Steuerungsmodulgehäuse 26 ist vorzugsweise aus einem Metall gebildet. Vorzugsweise ist das Steuerungsmodulgehäuse 26 aus einem Metallblech gebildet. Vorzugsweise ist das Steuerungsmodulgehäuse 26 aus einem Stahl gebildet. Das Steuerungsmodulgehäuse 26 ist vorzugsweise mehrteilig ausgebildet. Das Steuerungsmodulgehäuse 26 ist vorzugsweise von zwei Halbschalen 28, 30 gebildet. Die erste Halbschale 28 ist beispielhaft als eine Hauptschale ausgebildet, die einen Großteil des Steuerungsmodulgehäuses 26 ausbildet. Die zweite Halbschale 30 ist als ein Deckel ausgebildet, mit der die als Hauptschale ausgebildete Halbschale 28 verschließbar ist. Die beiden Halbschalen 28, 30 zusammen bilden das Steuerungsmodulgehäuse 26 aus. Die Halbschalen 28, 30 weisen jeweils einen Befestigungsflansch auf, über den die beiden Halbschalen 28, 30 über Schraubenverbindungen miteinander verbunden sind. Die Halbschalen 28, 30 sind vorzugsweise in einem montierten Zustand abgedichtet miteinander verbunden. Die Halbschalen 28, 30 dichten den Innenraum des Steuerungsmodulgehäuses 26 gegenüber einer Umwelt ab.

Das Steuerungsmodul 24 weist eine Steuereinheit 32 auf. Die Steuereinheit 32 ist als eine Recheneinheit ausgebildet. Die Steuereinheit 32 ist zur Steuerung der Solarmodulbefestigungsvorrichtung 10 ausgebildet. Die Steuereinheit 32 ist zur Steuerung der Antriebseinheit 22 vorgesehen. Die Steuereinheit 32 ist durch die Steuerung der Antriebseinheit 22 zur Steuerung einer Ausrichtung der schwenkbar gelagerten Solarmodule 12, 14 vorgesehen. Mittels der Steuereinheit 32 wird eine Ausrichtung der Solarmodule 12, 14 mittels der Antriebseinheit 22 gesteuert oder geregelt. Die Steuereinheit 32 ist dazu vorgesehen, die Antriebseinheit 22 so anzusteuern, dass die Solarmodule 12, 14 durch Rotation der Befestigungsachse 20 in eine gewünschte Neigung gebracht werden. In einem Normalbetrieb ist die Steuereinheit 32 dazu vorgesehen, die Antriebseinheit 22 so anzusteuern, dass die Solarmodule 12, 14 im Verlaufe eines Tages durch Rotation der Befestigungsachse 20 immer wieder optimal entsprechend dem aktuellen Sonnenstand ausgerichtet werden. Die Steuereinheit 32 ist vorzugsweise dazu vorgesehen, die Solarmodule 12, 14 in Abhängigkeit von bestimmten Witterungsbedingungen in andere Ausrichtungen, insbesondere Notfallausrichtungen auszurichten. Beispielsweise wäre es denkbar, dass die Steuereinheit 32 dazu vorgesehen ist, bei starkem Wind die Solarmodule 12, 14 möglichst parallel zu einem Untergrund auszurichten, um eine auf die Solarmodule 12, 14 wirkende Windlast zur verringern. Beispielsweise wäre es auch denkbar, dass die Steuereinheit 32 dazu vorgesehen ist, die Solarmodule 12, 14 in Abhängigkeit einer Windstärke und Windrichtung in eine angepasste Ausrichtung zu stellen. Vorzugsweise wird die Steuereinheit 32 zur Steuerung der Solarmodulbefestigungsvorrichtung 10 mit Steuersignalen und/oder Sensorsignalen gespeist. Vorzugsweise weist das Steuerungsmodul 24 eine Antenneneinheit 34 auf, über die die Steuereinheit 32 mit externen Steuereinheiten 32 kommunizieren kann.

Das Steuerungsmodul 24 weist ein Batteriefach 36 auf. Das Batteriefach 36 ist zur wechselbaren Aufnahme einer Batterie 38 vorgesehen. Das Batteriefach 36 ist vorzugsweise elektrisch mit der Steuereinheit 32 und der Antriebseinheit 22 gekoppelt. Über eine in dem Batteriefach 36 angeordnete Batterie 38 kann die Steuereinheit 32 und die Antriebseinheit 22 mit einer elektrischen Energie zum Betrieb versorgt werden. Mittels einer von einer in dem Batteriefach 36 angeordneten Batterie 38 bereitgestellten elektrischen Energie kann die Steuereinheit 32 die Solarmodulbefestigungsvorrichtung 10 steuern, insbesondere eine Ausrichtung der Solarmodule 12, 14 durch Rotation der Befestigungsachse 20 mittels Ansteuerung der Antriebseinheit 22, verändern. Vorzugsweise kann die Solarmodulbefestigungsvorrichtung 10, insbesondere die Steuereinheit 32 und die Antriebseinheit 34 mit der elektrischen Energie aus einer in dem Batteriefach 36 angeordneten Batterie 38 für mehrere Stunden, vorzugsweise für mehr als 8 Stunden betrieben werden.

Das Batteriefach 36 ist in dem Steuerungsmodulgehäuse 26 angeordnet. Das Batteriefach 36 ist als ein Teil des Steuerungsmodulgehäuses 26 ausgebildet. Das Batteriefach 36 ist in dem Innenraum des Steuerungsmodulgehäuses 26 angeordnet. Im Bereich des Batteriefachs 36 weist das Steuerungsmodulgehäuse 26 eine Öffnung 40 auf. Die Öffnung 40 ist hier in der Halbschale 28 des Steuerungsmodulgehäuses 26 angeordnet. Durch die Öffnung 40 ist das in dem Innenraum des Steuerungsmodulgehäuses 26 angeordnete Batteriefach 36 zugänglich. Das Steuerungsmodulgehäuse 26 weist eine Verschlusseinheit 42 auf, mittels der die Öffnung 40 verschleißbar ist. Mittels der Verschlusseinheit 42 ist die Öffnung 40 vorzugsweise abgedichtet verschließbar. Vorzugsweise kann in einem korrekt montierten Zustand der Verschlusseinheit 42 keine Flüssigkeit zwischen der Verschlusseinheit 42 und einem die Öffnung 40 begrenzenden Rand in den Innenraum des Steuerungsmodulgehäuses 26 eindringen. Die Verschlusseinheit 42 ist vorzugsweis als eine Deckeleinheit ausgebildet. Die Verschlusseinheit 42 ist vorzugsweise werkzeuglos, beispielsweise mittels einer Rastverbindung, mit dem Steuerungsmodulgehäuse 26 verbindbar, um die Öffnung 40 zu verschließen. Vorzugsweise wäre es denkbar, dass die Verschlusseinheit 42 mit einer in das Batteriefach 36 einzubringenden Batterie 38 verbunden ist.

Das Batteriefach 36 weist eine Gleitschieneneinheit 44 auf. Über die Gleitschieneneinheit 44 ist eine Batterie 38 in das Batteriefach 36 einschiebbar. Die Gleitschieneneinheit 44 bildet eine Gleitachse auf, entlang der eine Batterie 38 verschiebbar auf der Gleitschieneneinheit 44 gelagert ist Die Gleitschieneneinheit 44 weist vorzugsweise zwei Gleitschienen 46, 48 auf. Die Gleitschienen 46, 48 sind vorzugsweise auf gegenüberliegenden Innenwandungen des Steuerungsmodulgehäuses 26 angeordnet. Die Gleitschienen 46, 48 bilden vorzugsweise jeweils eine Gleitfläche aus, auf der eine Batterie 38 gleitend geführt werden kann. Die Batterie 38 zur Einbringung weist vorzugsweise zwei korrespondierend zu den Gleitschienen 46, 48 ausgebildete Führungselemente 50, 52 auf. Die Führungselemente 50, 52 der Batterie 38 sind hier beispielhaft in Seitenwandungen der Batterie 38 eingebracht. Grundsätzlich wäre es auch denkbar, dass die Führungselemente 50, 52 seitlich an eine Batterie 38 angebunden sind, oder dass die Führungselemente 50, 52 auf einer Unterseite oder Oberseite einer Batterie 38 angeordnet sind. Beispielsweise wäre auch denkbar, dass die Führungselemente 50, 52 von der ebenen Unterseite der Batterie 38 selbst ausgebildet sind. Grundsätzlich wäre es denkbar, dass die Gleitschieneneinheit 44 mehrere Gleitschienen 46, 48 ausweist, die unterschiedliche Größen und/oder Formen aufweisen, sodass über die Gleitschieneneinheit 44 einfach unterschiedliche Batterien 38, insbesondere Batterien 38 unterschiedlicher Größen und/oder mit unterschiedlichen Führungselementen 50 in dem Batteriefach 36 angeordnet werden können.

Das Steuerungsmodul 24 weist einen Hochvoltbereich 54 auf. In dem Hochvoltbereich 54 sind Hochvoltbauteile des Steuerungsmoduls 24 angeordnet. Das Steuerungsmodul 24 weist einen Niedervoltbereich 56 auf. In dem Niedervoltbereich 56 sind lediglich Niedervoltbauteile des Steuerungsmoduls 24 angeordnet. Der Hochvoltbereich 54 und der Niedervoltbereich 56 des Steuerungsmoduls 24 sind in dem Steuerungsmodulgehäuse 26 getrennt voneinander angeordnet. Der Hochvoltbereich 54 und der Niedervoltbereich 56 sind räumlich getrennt voneinander angeordnet und insbesondere voneinander elektrisch isoliert. Der Niedervoltbereich 56 ist in einem ersten, oberen Bereich des Steuerungsmodulgehäuses 26 angeordnet. Der Hochvoltbereich 54 ist in einem zweiten, unteren Bereich des Steuerungsmodulgehäuses 26 angeordnet.

Das Steuerungsmodulgehäuse 26 weist eine Trennwand 58 auf, die den Hochvoltbereich 54 von dem Niedervoltbereich 56 abtrennt. Die Trennwand 58 isoliert den Niedervoltbereich 56 elektrisch von dem Hochvoltbereich 54. Die Trennwand 58 ist zwischen dem Niedervoltbereich 56 und dem Hochvoltbereich 54 angeordnet. Die Trennwand 58 trennt den Niedervoltbereich 56 vorzugsweise komplett von dem Hochvoltbereich 54 ab. Durch die Trennwand 58 ist ein Eingreifen in den Hochvoltbereich 54 von dem Niedervoltbereich 56 nicht möglich.

Das Batteriefach 36 ist in dem Niedervoltbereich 56 angeordnet ist. Das Batteriefach 36 ist als ein Teil des Niedervoltbereichs 56 ausgebildet. Das Batteriefach 36 ist auf einer dem Hochvoltbereich 54 gegenüberliegenden Seite der Trennwand 58 angeordnet. Dadurch kann eine Batterie 38 in das Batteriefach 36 einbracht, oder aus diesem entfernt werden, ohne dass die Gefahr besteht, dass ein Monteur in Kontakt mit einer Komponente des Hochvoltbereichs 54 kommt. Dadurch kann vorteilhaft eine Sicherheit bei einem Batteriewechsel erhöht werden.

Das Batteriefach 36 weist ein elektrisches Kontaktmodul 60 auf. Das elektrische Kontaktmodul 60 ist zu einer automatischen elektrischen Verbindung einer in das Batteriefach 36 eingeführten Batterie 38 vorgesehen. Das elektrische Kontaktmodul 60 ist vorzugsweise auf einer der Öffnung 40 gegenüberliegenden Innenwand des Steuerungsmodulgehäuses 26 angeordnet. Das Kontaktmodul 60 weist vorzugsweise einen Pluspol und einen Minuspol auf, die dazu vorgesehen sind, automatisch mit einem entsprechenden Pluspol und einem entsprechenden Minuspol einer in das Batteriefach 36 eingeschobenen Batterie 38 in Kontakt zu kommen. Grundsätzlich ist es auch denkbar, dass das Kontaktmodul 60, bzw. der Pluspol und/oder der Minuspol des Kontaktmoduls 60 an einer anderen Stelle innerhalb des Batteriefachs 36 angeordnet sind.

Das Batteriefach 36 weist zwei Steckerelemente 62, 64 zur manuellen elektrischen Verbindung einer in dem Batteriefach 36 angeordneten Batterie 38 auf. Das erste Steckerelement 62 ist vorzugsweise als ein Pluspol ausgebildet. Das zweite Steckerelement 64 ist als ein Minuspol ausgebildet. Die Steckerelemente 62, 64 sind zu einer manuellen Kopplung mit einem entsprechenden Pol einer in dem Batteriefach 36 angeordneten Batterie 38 vorgesehen. Grundsätzlich wäre es auch denkbar, dass das Batteriefach 36 lediglich ein manuell verbindbares Steckerelement 62, 64 aufweist, das sowohl einen Minuspoil als auch einen Pluspol umfasst. Vorzugsweise wäre es auch denkbar, dass ein Batteriefach 36 mehrere Steckerelemente 62, 64 aufweist, die zur elektrischen Anbindung an unterschiedlich ausgebildete Batterien 38 vorgesehen sind.

Das Batteriefach 36 ist zu einer werkzeuglosen Montage, insbesondere zu einem werkzeuglosen Austausch einer Batterie 38 vorgesehen ist. Die Verschlusseinheit 42 kann zur Öffnung des Batteriefachs 36 von der Öffnung 40 werkzeuglos entfernt werden. Die Batterie 38 kann einfach über die Gleitschieneneinheit 44 aus dem Batteriefach 36 gezogen werden. Dabei lösen sich die Pole der Batterie 38 automatisch von dem Pluspol und dem Minuspol des Kontaktmoduls 60. Sollte die Batterie 38 über die Steckerelemente 62, 64 elektrisch an das Steuerungsmodul 24 angebunden sein, müssten diese zunächst von der Batterie 38 getrennt werden, bevor diese aus dem Batteriefach 36 entnehmbar ist. Eine neue Batterie 38 kann nach Entnehmen der alten Batterie 38 einfach über die Gleitschieneneinheit 44 in das Batteriefach 36 eingebracht werden und dann je nach Ausbildung der Batterie 38 automatisch über das Kontaktmodul 60 oder manuell über die Steckerelemente 62, 64 elektrisch mit dem Steuerungsmodul 24 gekoppelt werden.

Das Steuerungsmodul 24 ist dazu vorgesehen, die Steuereinheit 32 wahlweise von einer in dem Batteriefach 36 angeordneten Batterie 38, oder von einer externen Energiequelle, vorzugsweise von dem zumindest einen Solarmodul 12, 14 mit elektrischer Energie zu versorgen. Das Steuerungsmodul 24 ist dazu vorgesehen, die Antriebseinheit 22 wahlweise von einer in dem Batteriefach 36 angeordneten Batterie 38, oder von einer externen Energiequelle, vorzugsweise von dem zumindest einen Solarmodul 12, 14 mit elektrischer Energie zu versorgen. Das Steuerungsmodul 24 weist einen elektrischen Anschluss 66 auf, über den elektrische Leitungen angeschlossen werden, mittels denen vorzugsweise von den Solarmodulen 12, 14 erzeugter Starkstrom geleitet wird. Über den elektrischen Anschluss 66 ist das Steuerungsmodul 24 von den Solarmodulen 12, 14 mit einer elektrischen Energie versorgbar. Der elektrische Anschluss 66 ist in dem Hochvoltbereich 54 angeordnet. Die Steuereinheit 32 und die Antriebseinheit 22 sind elektrisch mit dem Batteriefach 36 verbunden. In einem Betriebszustand in dem die Solarmodule 12, 14 keinen Strom erzeugen, kann die Solarmodulbefestigungsvorrichtung 10, insbesondere die Steuereinheit 32 und die Antriebseinheit 22 mit elektrischer Energie der in dem Batteriefach 36 angeordneten Batterie 38 betrieben werden. In einem Betriebszustand in dem die Solarmodule 12, 14 einen elektrischen Strom erzeugen, kann die Solarmodulbefestigungsvorrichtung 10, insbesondere die Steuereinheit 32 und die Antriebseinheit 22 mit elektrischer Energie die von den Solarmodulen 12, 14 erzeugt wird, betrieben werden. In diesem Betriebszustand kann auch die in dem Batteriefach 36 angeordnete Batterie 38 durch den von den Solarmodulen 12, 14 erzeugten Strom geladen werden.

Das Steuerungsmodul 24 ist mit seinem Steuerungsmodulgehäuse 26 an der Befestigungsachse 20 starr montiert. Das Steuerungsmodulgehäuse 26 weist einen Anbindungsbereich 68 auf. Mit dem Anbindungsbereich 68 liegt das Steuerungsmodulgehäuse 26 an der Befestigungsachse 20 an.

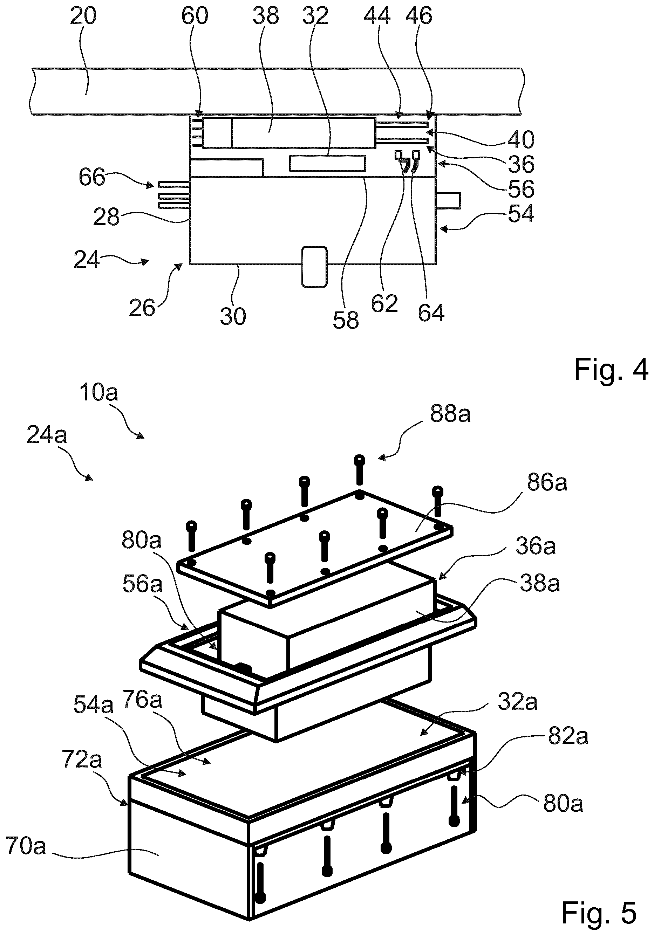

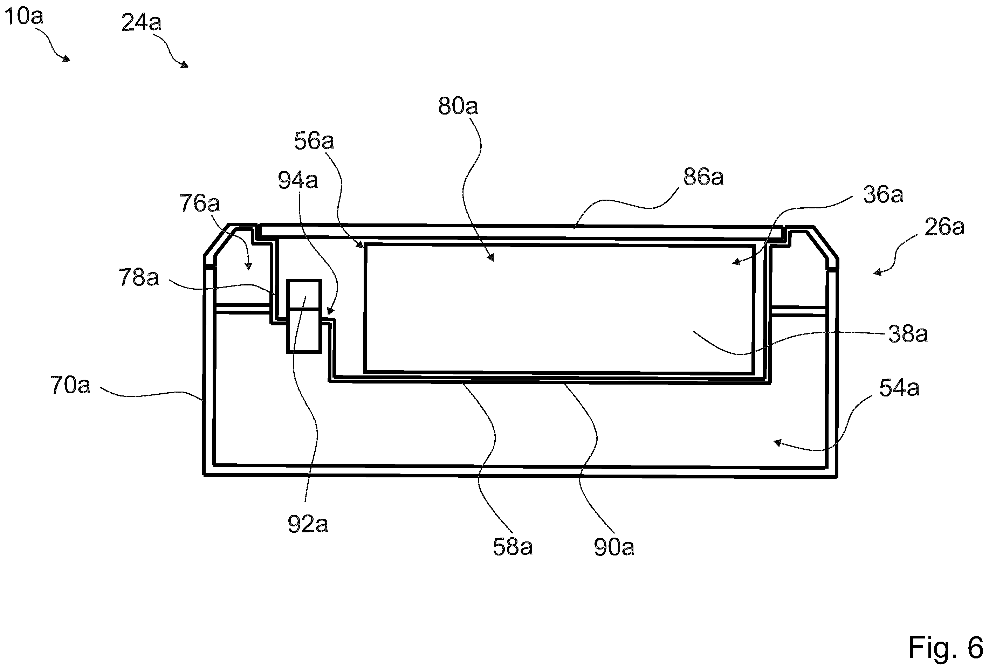

In den Figuren 5 bis 6 ist ein weiteres Ausführungsbeispiel der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Fig. 1 bis 4, verwiesen werden kann. Zur Unterscheidung der Ausführungsbeispiele ist in dem Ausführungsbeispiel der Figuren 5 bis 66 den Bezugszeichen der Buchstabe a nachgestellt.

Die Figuren 5 bis 6 zeigen eine erfindungsgemäße Solarmodulbefestigungsvorrichtung 10a in einem zweiten Ausführungsbeispiel. Die Solarmodulbefestigungsvorrichtung 10a ist Teil eines erfindungsgemäßen Solarsystems, das in diesem Ausführungsbeispiel nicht näher dargestellt ist. Das Solarsystem ist äquivalent zu dem des ersten Ausführungsbeispiels ausgeführt, und soll deshalb hier nicht nochmals näher beschrieben werden. Zur Erläuterung des Solarsystems soll auf die Beschreibung des ersten Ausführungsbeispiels verwiesen werden.

Die Solarmodulbefestigungsvorrichtung 10a weist ein Steuerungsmodul 24a auf. Das Steuerungsmodul 24a ist zur Steuerung der Solarmodulbefestigungsvorrichtung 10a vorgesehen. Das Steuerungsmodul 24a ist zur Steuerung einer Antriebseinheit des Solarsystems vorgesehen. Das Steuerungsmodul 24a weist eine Steuereinheit 32a auf. Die Steuereinheit 32a ist als eine Recheneinheit ausgebildet. Die Steuereinheit 32a ist zur Steuerung der Solarmodulbefestigungsvorrichtung 10a ausgebildet.

Das Steuerungsmodul 24a weist ein Steuerungsmodulgehäuse 26a auf. Das Steuerungsmodulgehäuse 26a bildet eine Umhausung für das Steuerungsmodul 24a. Das Steuerungsmodulgehäuse 26a spannt einen Innenraum des Steuerungsmoduls 24a. Das Steuerungsmodulgehäuse 26a ist vorzugsweise aus einem Metall gebildet. Das Steuerungsmodulgehäuse 26a ist mehrteilig ausgebildet. Das Steuerungsmodulgehäuse 26a ist modular ausgebildet. Das Steuerungsmodulgehäuse 26a weist ein Hauptgehäuse 70a auf. Das Hauptgehäuse 70a bildet einen Hauptteil des Steuerungsmodulgehäuses 26a aus. Das Hauptgehäuse 70a bildet ein Außengehäuse des Steuerungsmodulgehäuses 26a aus. Das Hauptgehäuse 70a begrenzt einen Innenraum des Steuerungsgehäuses vorzugsweise zu 5 Seiten hin. Das Hauptgehäuse 70a ist vorzugsweise zu einer Seite hin geöffnet. Das Hauptgehäuse 70a ist an einer Seite geöffnet. Das Hauptgehäuse 70a ist vorzugsweise wannenförmig ausgebildet. Das Hauptgehäuse 70a weist Längsseitenwandungen 72a, 74a auf. Die Längsseitenwandungen 72a, 74a sind vorzugsweise profiliert ausgebildet. Das Hauptgehäuse 70a bildet einen Hauptaufnahmeraum 76a aus.

Das Steuerungsmodulgehäuse 26a weist eine Innenschale 78a auf. Die Innenschale 78a ist wannenförmig ausgebildet. Die Innenschale 78a ist dazu vorgesehen, mit dem Hauptgehäuse 70a verbunden zu werden. Die Innenschale 78a ist dazu vorgesehen, sich in einem montierten Zustand zumindest teilweise in das Hauptgehäuse 70a zu erstrecken. Die Innenschale 78a erstreckt sich im montierten Zustand zumindest teilweise in den von dem Hauptgehäuse 70a aufgespannten Hauptaufnahmeraum 76a. Die Innenschale 78a weist einen wannenförmigen Aufnahmebereich 80a auf. Die Inneschale 78a ist mit dem wannenförmigen Aufnahmebereich 80a im montierten Zustand in dem Hauptaufnahmeraum 76a des Hauptgehäuses 70a angeordnet. Die Innenschale 78a weist einen Boden 90a auf. Der Boden 80a ist Teil des Aufnahmebereichs 80a. Die Innenschale 78a ist fest mit dem Hauptgehäuse 70a verbindbar. Die Innenschale 78a ist form- und/oder kraftschlüssig mit dem Hauptgehäuse 70a verbindbar. Die Innenschale 78a ist zerstörungsfrei trennbar mit dem Hauptgehäuse 70a verbindbar. Die Innenschale 78a ist mit dem Hauptgehäuse 70a verbindbar und kann wieder von diesem demontiert werden. Die Innenschale 78a ist vorzugsweise über Schraubenverbindungen mit dem Hauptgehäuse 70a verbunden. Die Innenschale 78a ist mittels mehrerer Schrauben 82a an dem Hauptgehäuse 70a fest montierbar. Die Schrauben 82a sind von unten mit dem Hauptgehäuse 70a und der Innenschale 78a verschraubt. Zur Anbindung der Innenschale 78a weist das Hauptgehäuse 70a an seiner geöffneten Seite einen Befestigungsflansch auf, auf dem die Innenschale 78a aufliegt. An dem Befestigungsflansch sind auf einer der Auflagefläche für die Innenschale 78a gegenüberliegenden Unterseite Befestigungsdome 84a angeordnet. Die Schrauben 82a sind in einem montierten Zustand durch die Befestigungsdome 84a geführt. Die Innenschale 78a weist in einem Anbindungsbereich mehrere Gewindelöcher auf, in die die Schrauben 82a zur Befestigung der Innenschale 78a an dem Hauptgehäuse 70a einschraubbar sind. Die Gewindelöcher sind hier nicht näher dargestellt. Die Gewindelöcher sind vorzugsweise einstückig mit der Innenschale 78a ausgebildet. Grundsätzlich wäre es auch denkbar, dass die Innenschale 78a Profillöcher aufweist, in die zur Anbindung der Schrauben 82a korrespondierende Muttern eingelegt sind, mit denen die Schrauben 82a zur Anbindung jeweils verschraubt werden.

Das Steuerungsmodulgehäuse 26a weist ein Deckelelement 86a auf. Das Deckelelement 86a ist dazu vorgesehen, das Steuerungsmodulgehäuse 26a in einem montierten Zustand zu verschließen. Das Deckelement 86a ist dazu vorgesehen, den Aufnahmebereich 80a der Innenschale 78a zu verschließen. Das Deckelelement 80a ist dazu vorgesehen, kraft- und/oder formschlüssig mit der Innenschale 78a verbunden zu werden. Das Deckelement 86a ist dazu vorgesehen, über Schraubenverbindungen fest mit der Innenschale 78a verbunden zu werden. Das Deckelement 86a ist mittels mehrerer Schrauben 88a an der Innenschale 78a fest montierbar. Die Schrauben 88a sind von oben mit dem Deckelelement 86a und der Innenschale 78a verbindbar. Die Schrauben 88a zur Befestigung des Deckelelements 86a an der Innenschale 78a sind von der gegenüberliegenden Seite befestigbar wie die Schrauben 82a zur Befestigung der Innenschale 78a an dem Hauptgehäuse 70a. Dadurch ist vorteilhaft eindeutig, welche Schrauben 88a zum Demontieren des Deckelements 86a und welche Schrauben 82a zur Demontage der Innenschale 78a gelöst werden müssen. Dadurch kann eine besonders vorteilhafte und eindeutige Montage/Demontage des Deckelements 86a für einen Monteur bereitgestellt werden.

Das Steuerungsmodul 24a weist ein Batteriefach 36a auf. Das Batteriefach 36a ist zur wechselbaren Aufnahme einer Batterie 38a vorgesehen. Das Batteriefach 36a ist vorzugsweise elektrisch mit der Steuereinheit 32a und einer Antriebseinheit 22a gekoppelt. Über eine in dem Batteriefach 36a angeordnete Batterie 38a kann die Steuereinheit 32a und die Antriebseinheit 22a mit einer elektrischen Energie zum Betrieb versorgt werden. Das Batteriefach 36a ist in dem Steuerungsmodulgehäuse 26a angeordnet. Das Batteriefach 36a ist als ein Teil des Steuerungsmodulgehäuses 26a ausgebildet. Das Batteriefach 36a ist in dem Innenraum des Steuerungsmodulgehäuses 26a angeordnet. Das Batteriefach 36a ist von der Innenschale 78a gebildet. Das Batteriefach 36a ist in dem Aufnahmebereich 80a der Innenschale 78a angeordnet. In dem Aufnahmebereich 80a, welches das Batteriefach 36a ausbildet, sind nicht näher dargestellte Befestigungsmittel angeordnet, mittels denen die Batterie 38a sicher in dem Batteriefach 36a angeordnet werden kann. Die Befestigungsmittel können beispielsweise als Formschlusselemente ausgebildet sein, in denen die Batterie 38a beispielsweise einclipsbar ist, oder auch als ein Flausch- und Hakenband, mittels dem die Batterie 38a in dem Batteriefach 36a gehalten werden kann. Die Batterie 38a liegt in einem montierten Zustand vorzugsweise auf dem Boden 90a der Innenschale 78a auf. In dem Aufnahmebereich 80a, der das Batteriefach 36a ausbildet, können unterschiedlich große Batterien 38a angeordnet und befestigt werden. Eine Montage oder ein Austausch einer Batterie 38a kann einfach, lediglich durch Entfernen des Deckelements 86a durch Entfernen der Schrauben 88a erfolgen.

Das Steuerungsmodul 24a weist einen Hochvoltbereich 54a auf. In dem Hochvoltbereich 54a sind Hochvoltbauteile des Steuerungsmoduls 24a angeordnet. Das Steuerungsmodul 24a weist einen Niedervoltbereich 56a auf. In dem Niedervoltbereich 56a sind lediglich Niedervoltbauteile des Steuerungsmoduls 24a angeordnet. Der Hochvoltbereich 54a und der Niedervoltbereich 56a des Steuerungsmoduls 24a sind in dem Steuerungsmodulgehäuse 26a getrennt voneinander angeordnet. Der Hochvoltbereich 54a und der Niedervoltbereich 56a sind vorzugsweise zumindest räumlich getrennt voneinander angeordnet und insbesondere voneinander elektrisch isoliert. Die Steuereinheit 32a weist vorzugsweise eine nicht näher dargestellte Platine auf, die zumindest in einen Hochvoltteilbereich und einen Niedervoltteilbereich aufgeteilt ist. Der Hochvoltteilbereich und der Niedervoltteilbereich sind dabei vorzugsweise durch entsprechende isolierende Elemente, wie beispielsweise durch Einschnitte voneinander getrennt. Das Batteriefach 36a ist in dem Niedervoltbereich 56a angeordnet. Das Batteriefach 36a ist als ein Teil des Niedervoltbereichs 56a ausgebildet. Der Hochvoltbereich 54a ist in dem Hauptaufnahmeraum 76a des Hauptgehäuses 70a angeordnet. Der Hochvoltbereich 54a ist in dem Bereich des Hauptaufnahmeraums 76a des Hauptgehäuses 70a angeordnet, der von der Innenschale 78a abgetrennt ist. Der Hochvoltbereich 54a ist zwischen einem Boden des Hauptgehäuses 70a und dem Boden 90a der Innenschale 78a angeordnet. Der Hochvoltbereich 54a ist von dem Batteriefach 36a getrennt. Der Hochvoltbereich 54a ist von durch die Innenschale 76a, insbesondere durch den Boden 90a der Innenschale 76a räumlich von dem Batteriefach 36a getrennt. Der Boden 90a der Innenschale 76a bildet eine Trennwand 58 aus, der Hochvoltbereich 54a galvanisch isoliert von dem Niedervoltbereich 56a abtrennt.

Die Steuereinheit 32a weist ein Steckerelement 92a auf. Über das Steckerelement 92a ist die Batterie 38a elektrisch an das Steuerungsmodul 24a anbindbar. Das Steckerelement 92a ist an der in dem Hochvoltbereich angeordneten Steuereinheit 32a angebunden. Das Steckerelement 92a ist an der Platine der Steuereinheit 32a angebunden. Das Steckerelement 92a ist vorzugsweise in dem Niedervoltteilbereich 56a der Platine der Steuereinheit 32a angebunden. Das Steckerelement 92a erstreckt sich von dem Hauptaufnahmeraum 76a des Hauptgehäuses 70a bis in den Aufnahmebereich 80a der Innenschale 78a, der das Batteriefach 36a ausbildet. Das Steckerelement 92a erstreckt sich bis in das Batteriefach 36a. Die Innenschale 78a weist in ihrem Boden 90a eine Ausnehmung 94a auf. Die Ausnehmung 94a weist eine Größe auf, die etwas größer ist als das Steckerelement 94a. Die Ausnehmung 94a ist dazu vorgesehen, dass das Steckerelement 92a durch sie hindurch ragt.

### Bezugszeichen

- 10: Solarmodulbefestigungsvorrichtu ng
- 12: Solarmodul
- 14: Solarmodul
- 16: Stützelement
- 18: Stützelement
- 20: Befestigungsachse
- 22: Antriebseinheit
- 24: Steuerungsmodul
- 26: Steuerungsmodulgehäuse
- 28: Halbschale
- 30: Halbschale
- 32: Steuereinheit
- 34: Antenneneinheit
- 36: Batteriefach
- 38: Batterie
- 40: Öffnung
- 42: Verschlusseinheit
- 44: Gleitschieneneinheit
- 46: Gleitschiene
- 48: Gleitschiene
- 50: Führungselement
- 52: Führungselement
- 54: Hochvoltbereich
- 56: Niedervoltbereich
- 58: Trennwand
- 60: Kontaktmodul
- 62: Steckerelement
- 64: Steckerelement
- 66: elektrischer Anschluss
- 68: Anbindungsbereich
- 70: Hauptgehäuse
- 72: Längsseitenwandung
- 74: Längsseitenwandung
- 76: Hauptaufnahmeraum
- 78: Innenschale
- 80: Aufnahmebereich
- 82: Schraube
- 84: Befestigungsdom
- 86: Deckelelement
- 88: Schraube
- 90: Boden
- 92: Steckerelement
- 94: Ausnehmung

- 100: Solarsystem

## Patentansprüche

1. Solarmodulbefestigungsvorrichtung mit einer Solarmodulbefestigungseinheit, zur Anbindung zumindest eines Solarmoduls (12, 14), mit zumindest einer rotierbaren Befestigungsachse (20), an der zumindest die eine Solarmodulbefestigungseinheit angebunden ist, mit einer Antriebseinheit (22), die zum Antrieb der Befestigungsachse (20) vorgesehen ist, und mit einem Steuerungsmodul (24; 24a), das zumindest ein Steuerungsmodulgehäuse (26; 26a) und eine in dem Steuerungsmodulgehäuse (26; 26a) angeordnete Steuereinheit (32; 32a) zur Steuerung der Antriebseinheit (22) aufweist, **dadurch gekennzeichnet, dass** das Steuerungsmodul (24; 24a) ein in dem Steuerungsmodulgehäuse (26; 26a) angeordnetes Batteriefach (36; 36a) aufweist, das zur wechselbaren Aufnahme einer elektrischen Batterie (38; 38a) vorgesehen ist.

2. Solarmodulbefestigungsvorrichtung nach Anspruch 1, **dadurch gekennzeichnet, dass** das Batteriefach (36) eine Gleitschieneneinheit (44) aufweist, über die die Batterie (38) in das Batteriefach (36) einschiebbar ist.

3. Solarmodulbefestigungsvorrichtung nach Anspruch 1 oder 2, **dadurch gekennzeichnet, dass** das Steuerungsmodul (24; 24a) einen Hochvoltbereich (54; 54a) und einen Niedervoltbereich (56; 56a) aufweist, die in dem Steuerungsmodulgehäuse (26; 26a) getrennt voneinander angeordnet sind, wobei das Batteriefach (36; 36a) in dem Niedervoltbereich (56; 56a) angeordnet ist.

4. Solarmodulbefestigungsvorrichtung nach Anspruch 3, **dadurch gekennzeichnet, dass** der Hochvoltbereich (54; 54a) durch zumindest eine Trennwand (58; 58a), vorzugsweise isoliert, von dem Niedervoltbereich (56; 56a) abgetrennt ist.

5. Solarmodulbefestigungsvorrichtung nach einem der vorhergehenden Ansprüche, **dadurch gekennzeichnet, dass** das Batteriefach (36) ein elektrisches Kontaktmodul (60) aufweist, das dazu vorgesehen ist, mit einer in dem Batteriefach (36) korrekt angeordneten Batterie (38) automatisch elektrisch verbunden zu werden.

6. Solarmodulbefestigungsvorrichtung nach einem der vorhergehenden Ansprüche, **dadurch gekennzeichnet, dass** das Batteriefach (36) zumindest ein Steckerelement (62, 64) zur manuellen elektrischen Verbindung einer in dem Batteriefach (36) angeordneten Batterie (38) aufweist.

7. Solarmodulbefestigungsvorrichtung nach einem der vorhergehenden Ansprüche, **dadurch gekennzeichnet, dass** das Batteriefach (36) zu einer werkzeuglosen Montage, insbesondere zu einem werkzeuglosen Austausch einer Batterie (38) vorgesehen ist.

8. Solarmodulbefestigungsvorrichtung nach einem der vorhergehenden Ansprüche, **dadurch gekennzeichnet, dass** das Steuerungsmodul (24) dazu vorgesehen ist, die Steuereinheit (32) wahlweise von einer in dem Batteriefach (36) angeordneten Batterie (38), oder von einer externen Energiequelle, vorzugsweise von dem zumindest einen Solarmodul (12, 14) mit elektrischer Energie zu versorgen.

9. Solarmodulbefestigungsvorrichtung nach einem der vorhergehenden Ansprüche, **dadurch gekennzeichnet, dass** das Steuerungsmodul (24) mit seinem Steuerungsmodulgehäuse (26) an der Befestigungsachse (20) starr montiert ist.

10. Solarmodulbefestigungsvorrichtung nach einem der vorhergehenden Ansprüche, **dadurch gekennzeichnet, dass** das Steuerungsmodulgehäuse (26a) ein Hauptgehäuse (70a), das einen Hauptaufnahmeraum (76a) ausbildet, und eine Innenschale (78b) aufweist, die zumindest teilweise in dem Hauptaufnahmeraum (76a) angeordnet ist.

11. Solarmodulbefestigungsvorrichtung nach Anspruch 10, **dadurch gekennzeichnet, dass** die Innenschale (78a) einen Aufnahmebereich (80a) aufweist, der das Batteriefach (36a) ausbildet.

12. Solarsystem mit einer Solarmodulbefestigungsvorrichtung (10) nach einem der vorhergehenden Ansprüche, mit einem Steuerungsmodul (24), das ein Batteriefach (36) aufweist, und mit einer Batterie (38), die wechselbar, insbesondere werkzeuglos wechselbar, in dem Batteriefach (36) angeordnet ist.
